# FASCICULE DE BREVET EUROPEEN

(11) **EP 3 406 117 B1**
(45) Date de publication et mention de la délivrance du brevet: **25.08.2021**
(21) Numéro de dépôt: 17700585.7
(22) Date de dépôt: 19.01.2017
(51) Int. Cl.: H05K 5/06

(54) **DISPOSITIF ÉLECTRONIQUE ÉTANCHE ET SON PROCÉDÉ D'OBTENTION**
LECKDICHTE ELEKTRONISCHE VORRICHTUNG UND VERFAHREN ZUM ERHALT DAVON
LEAKTIGHT ELECTRONIC DEVICE AND METHOD OF OBTAINING SAME

(30) Priorité: 19.01.2016 FR 1650419
(43) Date de publication de la demande: 28.11.2018
(73) Titulaire: Valeo Comfort and Driving Assistance, 94046 Créteil Cedex (FR)
(72) Inventeur: DAVID, Marc, 94046 Créteil Cedex (FR)
(74) Mandataire: Delplanque, Arnaud
(86) Numéro de dépôt international: PCT/EP2017/051121
(87) Numéro de publication internationale: WO 2017/125516

(56) Documents cités:
- EP-A1- 0 472 199
- WO-A1-2014/132973
- US-A- 5 514 913

## Description

### DOMAINE TECHNIQUE AUQUEL SE RAPPORTE L'INVENTION

La présente invention concerne de manière générale le domaine des dispositifs étanches.

Elle concerne plus particulièrement un dispositif électronique étanche et un procédé d'obtention d'un tel dispositif.

Elle concerne en particulier une antenne étanche de réception d'ondes basses fréquences d'un véhicule automobile.

### ARRIERE-PLAN TECHNOLOGIQUE

Il est connu d'utiliser un identifiant, typiquement porté par un utilisateur d'un véhicule, pour que le véhicule puisse détecter l'approche de l'utilisateur. Lorsque l'utilisateur et le véhicule sont suffisamment proches l'un de l'autre, il est alors possible de commander automatiquement une fonctionnalité du véhicule, telle que le déverrouillage des portes du véhicule.

On prévoit dans ce but que l'identifiant soit capable d'émette un signal électromagnétique et que le véhicule comporte un module de réception adapté à réceptionner ce signal, de sorte que le véhicule et l'identifiant puissent communiquer l'un avec l'autre.

A cet effet, le module de réception du signal qui comprend généralement une antenne de réception d'ondes basses fréquences et doit préférentiellement être placé sur une partie extérieure du véhicule, parfois soumise à de mauvaises conditions climatiques, par exemple aux intempéries.

Or ce module de réception comprend des éléments électroniques qui doivent d'être protégés de ces mauvaises conditions climatiques.

Les documents EP0472199, US5514913 et WO2014/132973 décrivent les procédés d'obtention d'un dispositif électronique étanche.

### OBJET DE L'INVENTION

Afin de remédier à l'inconvénient précité de l'état de la technique, la présente invention propose de protéger de façon étanche l'antenne de réception des ondes basses fréquences.

Plus particulièrement, on propose selon l'invention un procédé d'obtention d'un dispositif électronique étanche selon lequel il est prévu des étapes consistant à :
a) placer un module électronique à l'intérieur d'un moule,
b) maintenir ledit module électronique à distance des parois dudit moule à l'aide de pattes de maintien présentant chacune une extrémité qui fait saillie vers l'intérieur du moule,
c) injecter dans ledit moule un matériau thermoplastique adapté à durcir pour former une coque d'étanchéité, lesdites pattes de maintien se rétractant vers l'extérieur du moule lors de l'injection dudit matériau thermoplastique caractérise en ce que au moins un sous-ensemble électronique du module électronique placé à l'intérieur du moule à l'étape a) est encapsulé dans une coque souple.

Avantageusement, les pattes de maintien étant adaptées à se rétracter vers l'extérieur du moule, le matériau thermoplastique entoure intégralement le module électronique, y compris en lieu et place des pattes le maintenant à distance des parois de moule.

En outre, ce procédé est simple à mettre en place.

D'autres caractéristiques non limitatives et avantageuses du procédé décrit ci-dessus sont les suivantes :
- ladite coque souple se déforme lors du durcissement dudit matériau thermoplastique ;
- le module électronique comprend une antenne et/ou au moins un circuit électronique ;
- à l'étape b), ledit module électronique est pincé entre au moins deux pattes de maintien positionnées de part et d'autre dudit module électronique ;
- à l'étape b), ladite extrémité de chaque patte de maintien en saillie vers l'intérieur du moule présente une portion en biseau tournée vers au moins une entrée par laquelle est injecté le matériau thermoplastique à l'étape c), de sorte que le matériau thermoplastique injecté exerce une force de pression sur ladite extrémité biseautée pour rétracter la patte de maintien ;
- chaque patte de maintien est montée dans ledit moule au moyen d'un ressort de sorte que, à l'étape b) ladite extrémité de la patte de maintien fasse saillie vers l'intérieur dudit moule, et à l'étape c) ladite extrémité puisse se rétracter, en particulier du fait de l'injection dudit matériau thermoplastique.

L'invention propose également un dispositif électronique étanche comprenant :
- un module électronique comportant un sous-ensemble électronique encapsulé dans une coque souple, et
- une coque d'étanchéité rigide entourant ledit module électronique.

Des caractéristiques non limitatives et avantageuses de ce dispositif sont les suivantes :
- la coque d'étanchéité rigide comprend un corps principal et une tête solidaire dudit corps de sorte que ledit dispositif électronique étanche est en un seul tenant ;
- la coque d'étanchéité comprend une ouverture à travers laquelle fait saillie une broche de connexion reliée électriquement audit module électronique ;
- le dispositif électronique étanche est adapté à être positionné sur un élément extérieur d'un véhicule automobile pour former une antenne de réception d'ondes basses fréquences.

### DESCRIPTION DETAILLEE D'UN EXEMPLE DE REALISATION

La description qui va suivre en regard des dessins annexés, donnés à titre d'exemples non limitatifs, fera bien comprendre en quoi consiste l'invention et comment elle peut être réalisée.

Sur les dessins annexés :
- la figure 1 est une représentation schématique de trois-quarts avant d'un dispositif électronique étanche selon l'invention ;
- la figure 2 est une représentation schématique en vue de dessus d'un module électronique compris dans le dispositif électronique de la figure 1 ;
- la figure 3 est une représentation schématique en vue de dessus d'une portion d'un moule adapté à la mise en œuvre de l'invention ;
- la figure 4 est une représentation schématique en coupe longitudinale dans le plan IV-IV du moule de la figure 3 contenant le module électronique de la figure 2 ;
- la figure 5 est une représentation schématique selon la coupe du plan IV-IV du dispositif électronique étanche de l'invention après mise en œuvre du procédé dans le moule de la figure 3.

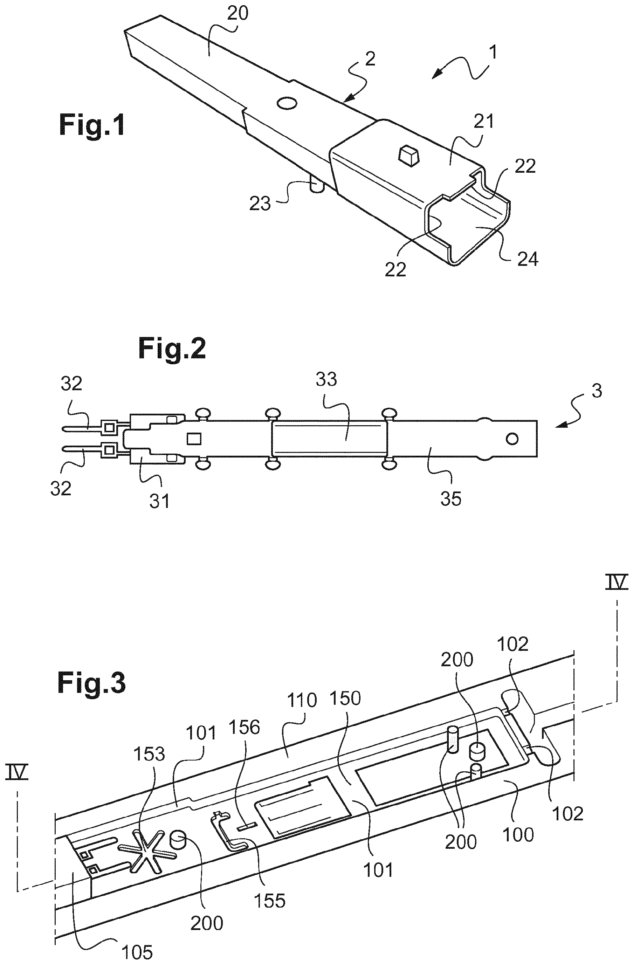

Sur la figure 1, on a représenté un dispositif électronique étanche 1 comprenant une coque d'étanchéité 2 rigide formé autour d'un module électronique 3 (visible en figure 2).

En pratique, ce dispositif électronique étanche 1 est adapté à être positionné sur un élément extérieur d'un véhicule automobile pour former une antenne de réception d'ondes basses fréquences.

La plage des basses fréquences considérée est ici proche de 125kHz ±3kHz.

Les ondes basses fréquences sont générées par un identifiant porté par un utilisateur. Lorsque l'identifiant s'approche suffisamment du dispositif électronique étanche, l'antenne qu'il forme reçoit lesdites ondes basses fréquences, ce qui déclenche, après traitement du signal porté par ces ondes basses fréquences et, éventuellement, échanges ultérieurs, une fonctionnalité dudit véhicule, par exemple le déverrouillage des portes du véhicule.

Plus précisément, la coque d'étanchéité 2 du dispositif électronique étanche 1 est réalisée en un matériau thermoplastique, c'est-à-dire un matériau polymère dont les propriétés mécaniques, de type élasticité, évoluent avec la température. Le matériau thermoplastique est adapté à être liquide à des températures supérieures à sa température de transition vitreuse, et adapté à durcir à des températures inférieures à sa température de transition vitreuse. Autrement dit, le matériau thermoplastique durcit par refroidissement. Ainsi, avantageusement, le matériau thermoplastique est tout à fait adapté à une utilisation dans des procédés par moulage.

Ici, le matériau thermoplastique est choisi pour avoir une température de transition vitreuse voisine de 60°C.

Le matériau thermoplastique est particulièrement rigide en-dessous de 60°C. Il est en outre étanche une fois durcit, c'est-à-dire imperméable à l'eau de sorte que, une fois le dispositif électronique étanche 1 monté sur le véhicule automobile, le module électronique qu'il renferme n'entre jamais en contact avec de l'eau.

Le matériau thermoplastique utilisé ici est un polybutylène téréphtalate renforcé par 30% environ, en masse par rapport à la masse totale du matériau thermoplastique, de fibre de verre. Ce matériau thermoplastique est plus connu sous le nom de PBT-GF30.

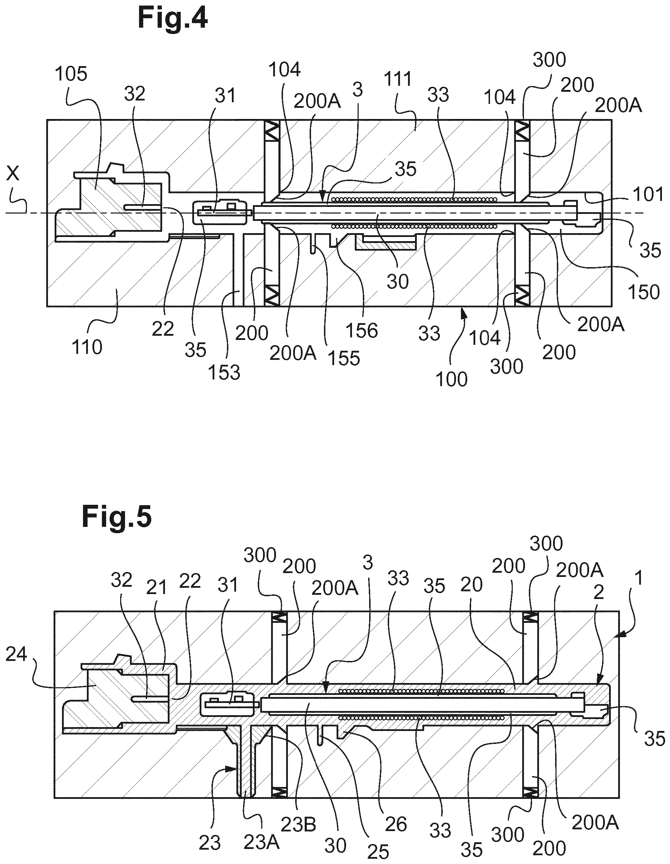

En pratique, et comme il sera expliqué plus en détails par la suite, la coque d'étanchéité 2 est formée autour du module électronique 3, par moulage de ce matériau thermoplastique (voir figure 4).

Comme le montrent les figures 1, 4 et 5, la coque d'étanchéité 2 rigide comprend un corps 20 principal et une tête 21 solidaire dudit corps 20 de sorte que ledit dispositif électronique étanche 1 est en un seul tenant.

Autrement dit, ici, le corps 20 et la tête 21 de la coque d'étanchéité 2 forme une seule pièce.

Le corps 20 s'étend globalement selon une direction principale d'extension X, et une des extrémités du corps est prolongée par la tête 21.

La tête 21 s'étend selon la même direction d'extension X, mais sur une distance plus courte.

Le corps 20 est plein, c'est-à-dire qu'en le traversant de part en part, on rencontre toujours de la matière.

Au contraire, la tête 21 est creuse et comprend quatre parois latérales qui débouchent sur une ouverture d'accès 24.

Ici, l'ouverture d'accès 24 est située à une des extrémités globales du dispositif électronique étanche 1. Elle permet la connexion électrique du dispositif électronique étanche 1 à une unité électronique extérieure, tout en assurant l'étanchéité dudit dispositif électronique étanche 1.

A cet effet de connexion, la tête 21 de la coque d'étanchéité 2 comprend une ouverture 22 à travers laquelle fait saillie une broche de connexion 32 reliée électriquement au module électronique 3 enfermé dans la coque d'étanchéité 2 (voir figures 4 et 5).

Ici, la coque d'étanchéité 2 présente deux ouvertures 22 à travers lesquelles font saillie deux broches de connexion 32 reliées électriquement audit module électronique 3.

Par ailleurs, il est prévu sur la coque d'étanchéité 2 une patte de fixation 23 dudit dispositif électronique étanche 1 à un élément extérieur du véhicule automobile.

En pratique, le dispositif électronique étanche 1 est fixé au parechoc arrière dudit véhicule automobile.

La patte de fixation 23 s'étend à partir du corps 20 principal, selon une direction globalement perpendiculaire à la direction d'extension dudit corps 20.

Elle présente une portion centrale 23A cylindrique relativement longue, autour de laquelle est formée une collerette en étoile 23B (voir figure 5).

Il est également prévu sur la coque d'étanchéité 2 deux pattes de support 25, 26 du dispositif électronique étanche 1 sur le véhicule automobile.

Ces pattes de support 25, 26 s'étendent également selon une direction globalement perpendiculaire à la direction d'extension du corps.

Le module électronique 3 enfermé dans le corps 20 de la coque d'étanchéité 2 s'étend selon la même direction d'extension X que celle dudit corps 20 (voir figures 4 et 5). Visuellement, ledit module électronique 3 forme un noyau central dudit corps 20.

Ici, ce module électronique 3 comprend une antenne et au moins un circuit électronique 31 (voir figure 2).

Le circuit électronique 31 est un circuit imprimé sur lequel sont connectées lesdites broches de connexion 32 et l'antenne.

En pratique, les broches de connexion 32 permettent d'alimenter électriquement le circuit électronique 31 à partir d'une source électrique extérieure audit dispositif électronique étanche 1 ; lorsque ce dernier est en position sur le véhicule automobile.

L'antenne comprend un matériau présentant des propriétés magnétiques entouré au moins partiellement par une bobine 33 métallique.

Plus précisément, elle est formée ici par un parallélépipède en ferrite 30 partiellement entouré par une bobine 33 en cuivre adaptée à interagir avec cet élément en ferrite 30.

L'élément en ferrite 30 de l'antenne et le circuit électronique 31 forme un sous-ensemble électronique du module électronique 3.

Avantageusement, le sous-ensemble électronique du module électronique 3 est encapsulé dans une coque souple 35.

La coque souple 35 est réalisée en un matériau thermoplastique polyamide. Ce matériau présente une grande souplesse de sorte que, à des températures supérieures ou égales à la température ambiante, il est adapté à se déformer facilement sous contrainte. Le matériau polyamide utilisé ici est le Macromelt®.

Ainsi, la coque souple 35 est adaptée à protéger les éléments les plus fragiles du module électronique 3, c'est-à-dire ici l'élément en ferrite 30 de l'antenne et le circuit électronique 31, pendant la formation de la coque d'étanchéité 2 lors du procédé de fabrication du dispositif électronique étanche 1.

En effet, cette coque souple 35 est adaptée à se déformer lorsqu'elle subit des contraintes liées au durcissement du matériau thermodurcissable. Le sous-ensemble électronique du module électronique 3 est alors protégé pendant ce durcissement.

En pratique, un fil de cuivre est enroulé autour d'une portion de la coque souple 35 de manière à former la bobine 33 de l'antenne.

En résumé, le module électronique 3 forme le cœur du dispositif électronique étanche 1. Le sous-ensemble électronique du module électronique 3 est encapsulé dans une coque souple 35 qui le protège, cette coque souple 35 est elle-même en partie entourée par la bobine 33 en cuivre adaptée à interagir avec l'élément en ferrite 30 pour former l'antenne, et le module électronique 3 ainsi formé est enfermé dans une coque d'étanchéité 2 rigide.

La partie qui suit détaille le procédé mis en œuvre pour obtenir un tel dispositif électronique étanche 1.

De manière remarquable, il est prévu selon ce procédé des étapes consistant à :
a) placer le module électronique 3 à l'intérieur d'un moule 100,
b) maintenir ledit module électronique 3 à distance des parois 101 dudit moule 100 à l'aide de pattes de maintien 200 présentant chacune une extrémité 201 qui fait saillie vers l'intérieur du moule 100,
c) injecter dans ledit moule 100 le matériau thermoplastique adapté à durcir pour former la coque d'étanchéité 2, lesdites pattes de maintien 200 se rétractant vers l'extérieur du moule 100 lors de l'injection du matériau thermoplastique, ici du fait de l'injection dudit matériau thermoplastique.

De façon avantageuse, à l'étape a), le module électronique 3 est déjà encapsulé dans la coque souple 35 décrite précédemment.

Autrement dit, avant son insertion dans le moule 100, le module électronique 3 est déjà prêt à être mis en contact avec le matériau thermoplastique de l'étape c).

Autrement dit, le sous-ensemble électronique du module électronique 3 est déjà encapsulé dans la coque souple 35 décrite précédemment, et une portion de cette coque souple 35 reçoit déjà la bobine 33 en cuivre de l'antenne.

Pour ce faire, on peut envisager qu'il soit prévu, préalablement à l'étape a), une étape d'encapsulation du sous-ensemble électronique du module électronique 3 dans ladite coque souple 35.

En variante, on pourrait envisager de se procurer le sous-ensemble électronique du module électronique déjà encapsulé avant de mettre en œuvre l'étape a) du procédé.

Avantageusement, ladite coque souple 35 est adaptée à se déformer lors du durcissement du matériau thermoplastique (par exemple à l'étape c) ou postérieurement à l'étape c)).

De façon avantageuse, à l'étape a), le module électronique 3 est déjà prêt à être mis en contact avec le matériau thermoplastique de l'étape c).

Une fois le sous-ensemble électronique du module électronique 3 encapsulé dans la coque souple 35, il est prévu de créer la bobine 33 autour de ladite coque souple 35.

Pour ce faire, un fil de cuivre est enroulé autour d'une portion de la coque souple 35 enfermant au moins une partie de l'élément en ferrite 30 de l'antenne (voir figure 2).

Sur les figures 3 à 5, on a représenté le moule 100 adapté à la mise en œuvre de ce procédé.

Sur la figure 5, seuls le dispositif électronique étanche 1 obtenu à l'issu du procédé et les pattes de maintien 200 sont référencés, le reste du moule 100 étant identique à celui représenté sur la figure 4.

Comme le montre la figure 4, le moule 100 comprend un fond 110 et un couvercle 111 adaptés à être positionnées l'un au dessus de l'autre de manière à former le moule 100.

A l'étape a), on place le module électronique 3 dans le fond 110 du moule 100 et on positionne le couvercle 111 par-dessus, de manière à fermer le moule 100.

Lorsque le fond 110 et le couvercle 111 du moule 100 sont positionnés l'un au-dessus de l'autre, le moule 100 est fermé et présente alors des parois 101 délimitant une cavité 150. Par abus de langage, on peut dire que la cavité 150 forme alors l'intérieur du moule 100.

Cette cavité 150 présente ici une forme globalement parallélépipédique.

Deux entrées 102 sont prévues à une première extrémité de ladite cavité 150 et sont destinées à l'injection, à l'étape c), dudit matériau thermoplastique dans ladite cavité 150. Cette première extrémité est appelée extrémité d'injection.

A l'autre extrémité de la cavité 150, le moule 100 comprend un obstacle 105 conformé autour duquel est moulée la tête 21 de la coque d'étanchéité 2 du dispositif électronique étanche 1 (voir figure 3). Autrement dit, l'obstacle 105 est destiné à former l'ouverture 24 de la tête 21 de ladite coque d'étanchéité 2, lors de l'étape c).

La cavité 150 présente en outre, dans la paroi 101 principale du fond 110 du moule 100, trois renfoncements 153, 155, 156 destinés à accueillir le matériau thermoplastique lors de l'étape c) du procédé pour former respectivement la patte de fixation 23 et les pattes de support 25, 26 dudit dispositif électronique étanche 1 (voir figures 3 et 4).

Par ailleurs, les parois 101 principales du fond 110 et du couvercle 111 du moule 100 comportent des ouvertures de passage 104 destinées à être traversées par les pattes de maintien 200 à l'étape b) du procédé (voir figure 4).

Plus précisément, ces parois 101 principales du fond 110 et du couvercle 111 du moule 100, en regard l'une de l'autre, comprennent chacune au moins une ouverture de passage 104 (voir figures 4).

Ici, la paroi 101 principale du fond 110 du moule 100 comprend quatre ouvertures de passage et la paroi 101 principale du couvercle 111 du moule 100 comprend également quatre ouvertures de passage en vis-à-vis de celles de ladite paroi 101 principale du fond 110 du moule 100.

Sur chacune de ces parois 101 principales, deux ouvertures de passages 104 sont alignées selon un axe longitudinal central du moule 100, et deux ouvertures de passages 104 sont alignées selon un axe transversal du moule 100, à proximité de l'extrémité d'injection de la cavité 150.

Chaque patte de maintien 200 traverse une des ouvertures de passage 104 du moule 100.

Plus précisément, à l'étape b), l'extrémité de chaque patte de maintien 200 fait saillie à l'intérieur du moule 100, c'est-à-dire dans la cavité 150.

A cet effet, chaque patte de maintien 200 est montée dans ledit moule 100 au moyen d'un ressort 300, de sorte que, lorsque ledit ressort 300 est au repos, à savoir lorsqu'il est non contraint, la patte de maintien 200 forme un plot à l'intérieur du moule 100.

Comme le montre la figure 4, le ressort 300 est interposé entre la patte de maintien 200 correspondante et le moule 100.

Ainsi, grâce à la position des ouvertures de passage en vis-à-vis deux à deux, à l'étape b) ledit module électronique 3 est pincé entre au moins deux pattes de maintien 200 positionnées de part et d'autre dudit module électronique 3.

Ces deux pattes de maintien 200 forment une paire de pattes de maintien 200 pinçant ledit module électronique 3.

Ici, le module électronique 3 est pincé entre huit pattes de maintien 200, soit quatre paires de pattes de maintien 200.

Le module électronique 3 est maintenu à distance des parois 101 dudit moule 100 (voir figure 4) grâce à ces pattes de maintien 200.

En outre, avantageusement, les deux paires de pattes de maintien 200 alignées longitudinalement évitent au module électronique 3 de basculer longitudinalement, c'est-à-dire qu'elles évitent au circuit électronique 31 d'une part, et à l'extrémité de l'antenne d'autre part, de se rapprocher des parois 101 principales du moule 100, notamment lors de l'injection du matériau thermoplastique.

Similairement, les deux paires de pattes de maintien 200 alignées transversalement évitent au module électronique 3 de basculer transversalement, c'est-à-dire qu'elles évitent au module électronique 3 d'avoir un mouvement de rotation autour de l'axe longitudinal central du moule 100, notamment lors de l'injection du matériau thermoplastique.

Par ailleurs, avantageusement, il est possible de comprimer le ressort 300 sur lequel chaque patte de maintien 200 est montée, de manière à repousser ladite patte de maintien 200 vers l'extérieur du moule 100, c'est-à-dire en dehors de la cavité 150, pour qu'elle affleure la paroi 101 principale correspondante du moule 100.

Notamment, le matériau injecté à l'étape c) comprime ces ressorts 300.

Ainsi, chaque patte de maintien 200 est mobile en translation selon la direction de compression du ressort 300 sur lequel elle est montée, entre une position de repos selon laquelle elle fait saillie à l'intérieur du moule 100 (figure 4), et une position rétractée selon laquelle elle affleure la paroi 101 principale correspondante du moule 100 (figure 5).

Au cours de l'étape c) du procédé, les pattes de maintien 200 se rétractent sous l'effet de l'injection du matériau thermoplastique qui exerce une force de pression sur lesdites pattes de maintien 200 pour les repousser hors de la cavité 150.

Pour faciliter la rétractation des pattes de maintien 200 sous l'effet l'injection du matériau thermoplastique, ladite extrémité 200A de chaque patte de maintien en saillie vers l'intérieur du moule 100 présente une portion en biseau 200A.

Chaque portion en biseau 200A est tournée vers une des entrées 102 par lesquelles est injecté le matériau thermoplastique à l'étape c), de sorte que le matériau thermoplastique peut exercer une force de poussée selon la direction de compression du ressort 300 associé à la patte de maintien 200.

En variante, on pourrait envisager que chaque patte de maintien soit montée à pivotement dans le moule.

Selon cette variante, chaque patte de maintien serait montée dans le moule par l'intermédiaire d'un axe de rotation de sorte que, à l'étape c), elle soit forcée à se rétracter par pivotement autour de cet axe de rotation.

Ainsi, selon cette variante chaque patte de maintien serait mobile en rotation autour de son axe de rotation, entre une position de repos selon laquelle elle ferait saillie à l'intérieur du moule, et une position rétractée selon laquelle elle affleurerait la paroi du moule.

Au cours de l'injection du matériau thermoplastique, ledit matériau thermoplastique exercerait une force de pression sur la portion biseautée, ce qui ferait pivoter la patte de maintien autour de son axe de rotation.

Selon une autre variante encore, on pourrait prévoir que chaque patte de maintien soit rétractée lors de l'injection par des moyens mécaniques actifs (et non du fait seulement des efforts générés par le matériau injecté dans le moule, comme décrit ci-dessus). De tels moyens mécaniques actifs pourraient être programmés pour agir en synchronisme par rapport à l'injection de matière.

Par ailleurs, quelle que soit la variante de réalisation envisagée, lorsque le matériau thermoplastique injecté a suffisamment durci pour former la coque d'étanchéité 2 du dispositif électronique étanche 1, le fond 110 et le couvercle 111 du moule 100 sont séparées de manière à accéder à l'intérieur du moule 100 et à en extraire ledit dispositif électronique étanche 1.

## Revendications

1. Procédé d'obtention d'un dispositif électronique étanche (1) selon lequel il est prévu des étapes consistant à :
a) placer un module électronique (3) à l'intérieur d'un moule (100),
b) maintenir ledit module électronique (3) à distance des parois (101) dudit moule (100) à l'aide de pattes de maintien (200) présentant chacune une extrémité qui fait saillie vers l'intérieur du moule (100),
c) injecter dans ledit moule (100) un matériau thermoplastique adapté à durcir pour former une coque d'étanchéité (2), lesdites pattes de maintien (200) se rétractant vers l'extérieur du moule (100) lors de l'injection dudit matériau thermoplastique
**caractérisé en ce que** au moins un sous-ensemble électronique du module électronique (3) placé à l'intérieur du moule à l'étape a) est encapsulé dans une coque souple (35).

2. Procédé selon la revendication 1, selon lequel ladite coque souple (35) se déforme lors du durcissement dudit matériau thermoplastique.

3. Procédé selon l'une des revendications 1 à 2, selon lequel le module électronique (3) comprend une antenne.

4. Procédé selon l'une des revendications 1 à 3, selon lequel le module électronique (3) comprend au moins un circuit électronique (31).

5. Procédé selon l'une des revendications 1 à 4, selon lequel, à l'étape b), ledit module électronique (3) est pincé entre au moins deux pattes de maintien (200) positionnées de part et d'autre dudit module électronique (3).

6. Procédé selon l'une des revendications 1 à 5, selon lequel, à l'étape b), ladite extrémité de chaque patte de maintien (200) en saillie vers l'intérieur du moule (100) présente une portion en biseau (200A) tournée vers au moins une entrée (102) par laquelle est injecté le matériau thermoplastique à l'étape c), de sorte que le matériau thermoplastique injecté exerce une force de pression sur ladite extrémité biseautée pour rétracter la patte de maintien (200).

7. Procédé selon l'une des revendications 1 à 6, selon lequel chaque patte de maintien (200) est montée dans ledit moule (100) au moyen d'un ressort (300) de sorte que, à l'étape b) ladite extrémité de la patte de maintien (200) fasse saillie vers l'intérieur dudit moule (100), et à l'étape c) ladite extrémité puisse se rétracter.

8. Dispositif électronique étanche (1) obtenu selon le procédé tel que défini dans l'une quelconque des revendications 1 à 7 comprenant :
- un module électronique (3) comportant un sous-ensemble électronique encapsulé dans une coque souple (35), et
- une coque d'étanchéité (2) rigide entourant ledit module électronique (3).

9. Dispositif électronique étanche (1) selon la revendication 8 selon lequel, la coque d'étanchéité (2) rigide comprend un corps principal (20) et une tête (21) solidaire dudit corps (20) de sorte que ledit dispositif électronique étanche (1) est en un seul tenant.

10. Dispositif électronique étanche (1) selon l'une des revendications 8 et 9, selon lequel la coque d'étanchéité (2) comprend une ouverture (22) à travers laquelle fait saillie une broche de connexion (32) reliée électriquement audit module électronique (3).

11. Dispositif électronique étanche (1) selon l'une des revendications 8 à 10, adapté à être positionné sur un élément extérieur d'un véhicule automobile pour former une antenne de réception d'ondes basses fréquences.

## Patentansprüche

1. Verfahren zum Erhalt einer leckdichten elektronischen Vorrichtung (1), wobei Schritte vorgesehen sind, die in Folgendem bestehen aus:
a) Legen eines elektronischen Moduls (3) in das Innere einer Form (100),
b) Halten des elektronischen Moduls (3) in einem Abstand zu den Wänden (101) der Form (100) mithilfe von Haltestiften (200), die jeweils ein Ende aufweisen, das in das Innere der Form (100) vorragt,
c) Einspritzen eines thermoplastischen Materials, das zur Aushärtung geeignet ist, um eine Dichtungsummantelung (2) zu bilden, in die Form (100), wobei die Haltestifte (200) sich beim Einspritzen des thermoplastischen Materials in das Äußere der Form (100) zurückziehen,
**dadurch gekennzeichnet, dass** mindestens eine elektronische Teilbaugruppe des elektronischen Moduls (3), das in Schritt a) in das Innere der Form gelegt wird, in einer weichen Ummantelung (35) verkapselt wird.

2. Verfahren nach Anspruch 1, wobei sich die weiche Ummantelung (35) beim Aushärten des thermoplastischen Materials verformt.

3. Verfahren nach einem der Ansprüche 1 bis 2, wobei das elektronische Modul (3) eine Antenne umfasst.

4. Verfahren nach einem der Ansprüche 1 bis 3, wobei das elektronische Modul (3) mindestens einen elektronischen Schaltkreis (31) umfasst.

5. Verfahren nach einem der Ansprüche 1 bis 4, wobei in Schritt b) das elektronische Modul (3) zwischen mindestens zwei Haltestiften (200) eingeklemmt wird, die beiderseits des elektronischen Moduls (3) positioniert sind.

6. Verfahren nach einem der Ansprüche 1 bis 5, wobei in Schritt b) das gegen das Innere der Form (100) vorragende Ende jedes Haltestifts (200) einen abgeschrägten Abschnitt (200A) aufweist, der gegen mindestens eine Eintrittsöffnung (102) gerichtet ist, durch die das thermoplastische Material in Schritt c) eingespritzt wird, so dass das eingespritzte thermoplastische Material eine Druckkraft auf das abgeschrägte Ende ausübt, um den Haltestift (200) zurückziehen zu lassen.

7. Verfahren nach einem der Ansprüche 1 bis 6, wobei jeder Haltestift (200) mittels einer Feder (300) so in der Form (100) montiert ist, dass in Schritt b) das Ende des Haltestifts (200) in das Innere der Form (100) vorragt und in Schritt c) das Ende sich zurückziehen kann.

8. Leckdichte elektronische Vorrichtung (1), die nach dem Verfahren nach einem der Ansprüche 1 bis 7 erhalten wird, umfassend:
- ein elektronisches Modul (3), umfassend eine elektronische Teilbaugruppe, die in einer weichen Ummantelung (35) verkapselt ist, und
- eine steife Dichtungsummantelung (2), die das elektronische Modul (3) umgibt.

9. Leckdichte elektronische Vorrichtung (1) nach Anspruch 8, wobei die steife Dichtungsummantelung (2) einen Hauptkörper (20) und einen fest mit dem Körper (20) verbundenen Kopf (21) umfasst, so dass die leckdichte elektronische Vorrichtung (1) einstückig ist.

10. Leckdichte elektronische Vorrichtung (1) nach einem der Ansprüche 8 und 9, wobei die Dichtungsummantelung (2) eine Öffnung (22) umfasst, durch die ein Anschlussstift (32) vorragt, der elektrisch mit dem elektronischen Modul (3) verbunden ist.

11. Leckdichte elektronische Vorrichtung (1) nach einem der Ansprüche 8 bis 10, die dazu geeignet ist, auf einem äußeren Element eines Kraftfahrzeugs positioniert zu werden, um eine Empfangsantenne für niederfrequente Wellen zu bilden.

## Claims

1. Method for obtaining a leaktight electronic device (1), in which the following steps are provided:
a) placing an electronic module (3) inside a mold (100),
b) keeping said electronic module (3) away from the walls (101) of said mold (100) with the aid of holding lugs (200) that each have an end which protrudes toward the inside of the mold (100),
c) injecting into said mold (100) a thermoplastic material designed to harden so as to form a leaktight shell (2), said holding lugs (200) retracting toward the outside of the mold (100) during the injection of said thermoplastic material,
**characterized in that** at least one electronic subassembly of the electronic module (3) placed inside the mold in step a) is encapsulated in a flexible shell (35) .

2. Method according to Claim 1, wherein said flexible shell (35) deforms while said thermoplastic material hardens.

3. Method according to either of Claims 1 and 2, wherein the electronic module (3) comprises an antenna.

4. Method according to one of Claims 1 to 3, wherein the electronic module (3) comprises at least one electronic circuit (31).

5. Method according to one of Claims 1 to 4, wherein, in step b), said electronic module (3) is gripped between at least two holding lugs (200) positioned on either side of said electronic module (3).

6. Method according to one of Claims 1 to 5, wherein, in step b), said end of each holding lug (200) that protrudes toward the inside of the mold (100) has a beveled portion (200A) facing at least one inlet (102) through which the thermoplastic material is injected in step c), such that the thermoplastic material injected exerts a pressure force on said beveled end in order to retract the holding lug (200).

7. Method according to one of Claims 1 to 6, wherein each holding lug (200) is mounted in said mold (100) by means of a spring (300) such that, in step b), said end of the holding lug (200) protrudes toward the inside of said mold (100) and, in step c), said end can retract.

8. Leaktight electronic device (1) obtained according to the method as defined in any one of Claims 1 to 7, comprising:
- an electronic module (3) having an electronic subassembly encapsulated in a flexible shell (35), and
- a rigid leaktight shell (2) surrounding said electronic module (3).

9. Leaktight electronic device (1) according to Claim 8, wherein the rigid leaktight shell (2) comprises a main body (20) and a head (21) integral with said body (20) such that said leaktight electronic device (1) is in one piece.

10. Leaktight electronic device (1) according to either of Claims 8 and 9, wherein the leaktight shell (2) comprises an opening (22) through which there projects a connection pin (32) electrically connected to said electronic module (3).

11. Leaktight electronic device (1) according to one of Claims 8 to 10, which is designed to be positioned on an exterior element of a motor vehicle in order to form an antenna for receiving low-frequency waves.
